(19) Europäisches Patentamt
European Patent Office
Office européen des brevets

(11) **EP 3 167 482 B1**

(12) **EUROPEAN PATENT SPECIFICATION**

(45) Date of publication and mention
of the grant of the patent:
**14.07.2021 Bulletin 2021/28**

(51) Int Cl.:
*H01L 23/49* (2006.01)     *C22C 9/00* (2006.01)
*C22F 1/08* (2006.01)     *H01B 1/02* (2006.01)

(21) Application number: **15721617.7**

(22) Date of filing: **28.04.2015**

(86) International application number:
**PCT/EP2015/059183**

(87) International publication number:
**WO 2016/005068 (14.01.2016 Gazette 2016/02)**

(54) **PROCESS FOR MANUFACTURING OF A THICK COPPER WIRE FOR BONDING APPLICATIONS**

VERFAHREN ZUR HERSTELLUNG EINES DICKEN KUPFERDRAHTS FÜR BINDUNGSANWENDUNGEN

PROCÉDÉ DE FABRICATION D'UN FIL DE CUIVRE ÉPAIS POUR DES APPLICATIONS DE CONNEXION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.07.2014 EP 14176650**

(43) Date of publication of application:
**17.05.2017 Bulletin 2017/20**

(73) Proprietor: **Heraeus Deutschland GmbH & Co. KG
63450 Hanau (DE)**

(72) Inventors:
• **MILKE, Eugen
61130 Nidderau (DE)**
• **AINOUZ, Larbi
CH-8832 Wilen Bei Wollerau (CH)**
• **PRENOSIL, Peter
63454 Hanau (DE)**

(74) Representative: **Heraeus IP
Heraeus Holding GmbH
Intellectual Property
Heraeusstraße 12-14
63450 Hanau (DE)**

(56) References cited:
EP-A1- 2 221 861     EP-A1- 2 461 358
EP-A1- 2 662 890     DE-A1-102010 031 993
JP-A- 2001 176 913     JP-A- 2009 140 953

**Description**

The invention is related to a process for the manufacture of a thick copper bonding wire.

Bonding wires are used in the manufacture of semiconductor devices for electrically interconnecting an integrated circuit and a printed circuit board during semiconductor device fabrication. Further, bonding wires are used in power electronic applications to electrically connect transistors, diodes and the like with pads or pins of the housing. While bonding wires were made from gold in the beginning, nowadays less expensive materials are used such as copper. While copper wire provides very good electric and thermal conductivity, ball-bonding as well as wedge-bonding of copper wire has its challenges. Moreover, copper wires are susceptible to oxidation.

With respect to wire geometry, most common are bonding wires of circular cross-section and bonding ribbons which have a more or less rectangular cross-section. Both types of wire geometries have their advantages making them useful for specific applications. Thus, both types of geometry have their share in the market. For example, bonding ribbons have a larger contact area for a given cross-sectional area. However, bending of the ribbons is limited and orientation of the ribbon must be observed when bonding in order to arrive at acceptable electrical contact between the ribbon and the element to which it is bonded. Turning to bonding wires, these are more flexible to bending.

However, bonding involves welding and larger deformation of the wire in the bonding process, which can cause harm or even destroy the bond pad and underlying electric structures of the element, which is bonded thereto.

For the present invention, the term bonding wire comprises all shapes of cross-sections. The dimension of the bonding wires made by the process of the invention is concerning thick bonding wires. In the present sense of bonding wires, a thick wire is considered a wire with a cross sectional area in the range of 7500 to 600000 $\mu$m$^2$ or 12000 to 600000 $\mu$m$^2$. In the example of a wire with circular cross section, such wire may have a diameter in the range of 98 to 510 $\mu$m or 125 to 510 $\mu$m. In order to achieve sufficient throughput and reliability, the mechanical properties and the bonding behavior of thick bonding wires comprises specific demands in comparison with thin bonding wires.

Some recent developments were directed to bonding wires having a copper core. As core material, copper is chosen because of high electric conductivity. Different dopants to the copper material have been searched for in order to optimize the bonding properties. For example, US 7,952,028 B2 describes several different copper-based test wires with a large number of different dopants and concentrations. Nevertheless, there is an ongoing need for further improving bonding wire technology with regard to the bonding wire itself and the bonding processes.

Accordingly, it is an object of the invention to provide a process for the manufacture of improved bonding wires.

Thus, it is another object of the invention to provide a process for the manufacture of a bonding wire, which has good processing properties and which has no specific needs when interconnecting, thus saving costs.

It is also an object of the invention to provide a process for the manufacture of a bonding wire which has excellent electrical and thermal conductivity.

It is a further object of the invention to provide a process for the manufacture of a bonding wire which exhibits an improved reliability.

It is a further object of the invention to provide a process for the manufacture of a bonding wire which exhibits excellent bondability.

It is another object of the invention to provide a process for the manufacture of a bonding wire which shows an improved bondability with respect to a wedge bonding.

It is another object of the invention to provide a process for the manufacture of a bonding wire which shows an increased softness of the wire core before bonding.

It is another object of the invention to provide a process for the manufacture of a bonding wire which has improved resistance to corrosion and/or oxidation.

Surprisingly, wires made by the process of the invention have been found to solve at least one of the objects mentioned above. Further, systems and modules comprising the wires made by the process of the invention were found to be more reliable at the interface between the wire and other electrical elements, e.g., the printed circuit board, the pad/pin etc.

The invention relates to a process for the manufacture of a bonding wire comprising a core with a surface, wherein the core comprises $\geq$ 98.0% copper and has a cross sectional area in the range of 7500 to 600000 $\mu$m$^2$ and an elastic limit RP0.2 (yield strength) in the range of 40 to 95 N/mm$^2$, the process comprising the steps of

   (a) providing a copper core precursor;
   (b) drawing the precursor until a final diameter of the wire core is reached;
   (c) annealing the drawn wire at a minimum annealing temperature in the range of 650 to 1000 °C through its entire cross section for a minimum annealing time in the range of 4 seconds to 2 hours, preferably 4 seconds to 1 hour.

In an embodiment the annealing may be performed as a stationary or static annealing process and the minimum annealing time may then lie in the range of 4 seconds to 2 hours, preferably 4 seconds to 1 hour, whereas in case the annealing is carried out dynamically (i.e. with a moving wire) the minimum annealing time may lie in the range of 4 to 30 seconds.

If no other specific definition is provided, all contents or shares of components are presently given as shares in weight. In particular, shares given in percent are understood as weight-%, and shares given in ppm (parts per million) are understood as weight-ppm.

Such wire as made by the process of the invention is optimized with respect to its mechanical and bonding properties. In a more preferred embodiment of the invention, the elastic limit RP0.2 of the wire core or the wire is $\leq 90$ N/mm$^2$ and most preferred $\leq 85$ N/mm$^2$. A lower limit of the elastic limit RP0.2 is preferably $\geq 40$ N/mm$^2$ and most preferably $\geq 50$ N/mm$^2$. This particularly results in preferred and advantageous ranges for the yield strengths of a bonding wire made by the process of the invention. A bonding wire as made by the process of the invention preferably has an elastic limit RP0.2 in one or more of the ranges 40 - 95 N/mm$^2$, 50 - 95 N/mm$^2$, 40 - 90 N/mm$^2$, or 50 - 90 N/mm$^2$. In a very preferred embodiment, the elastic limit RP0.2 of the core or of the wire is in the range of 65 - 90 N/mm$^2$ or 65 - 85 N/mm$^2$.

An elastic limit of the wire or of the core is the same as a yield strength. For the definition of an elastic limit or yield strength, reference is made to the common understanding. The "yield strength" of a material is defined in engineering and materials science as the stress at which a material begins to deform plastically. Prior to the beginning of plastic deformation, the material will deform elastically and will return to its original shape when the applied stress is removed. Presently, the elastic limit or yield strength is defined by using an 0.2%-offset yield point of plastic deformation (RP0.2).

The elastic limit is understood as a property of the bonding wire as provided as a finished and packed product. Further it is understood that no excessive storage time, environmental impact or the like has been imposed on the wire. The elastic limit of the bonding wire is given in its state before it is fed into a bonding tool.

It is pointed out that any mechanical stress, bending, heating, long storage time or the like can influence the microstructure of the wire and its elastic limit. For example, there is usually a significant difference between the elastic limit of a wire immediately after leaving an annealing oven and the same wire as a finished product in a packaged state.

It is understood that the elastic limit of the wire can be adjusted in particular by accordingly choosing the parameters of the annealing procedure. According to the invention, this does not necessarily mean to anneal the wire to a maximum of an elongation value, as it is common in prior art. Instead, the annealing procedure and further parameters of the wire (copper purity, additives etc.) are chosen to achieve the elastic limit values according to the invention.

A core of the wire is defined as a homogenous region of bulk material below a surface. As any bulk material basically has a surface region with different properties to some extent, the properties of the core of the wire are understood as properties of this bulk material region. The surface of the bulk material region can differ in terms of morphology, composition (e.g. oxygen content) or other features. The surface can be an outer surface of the wire in preferred embodiments. In further embodiments, the surface of the wire core can be provided as an interface region between the wire core and a coating layer superimposed on the wire core.

The wire is a bonding wire in particular for bonding in microelectronics. The wire is preferably a one-piece object.

A component is a "main component" if the share of this component exceeds all further components of a referenced material. Preferably, a main component comprises $\geq 50\%$ of the total weight of the material.

The copper content of the core is $\geq 98.0\%$. Even more preferred, the copper content is $\geq 99\%$. Further preferred, the wire core consists of copper with a purity of $\geq 99.9\%$ (3N-copper). Most preferred, the wire core consists of copper with a purity of $\geq 99.99\%$ (4N-copper). Pure copper wires generally show a good conductivity and good bonding properties. In alternative embodiments, small amounts of additional elements can be provided in the wire core. Examples for such elements include Pd, Ag or B.

In a generally preferred aspect of the invention, the elongation value of the wire after annealing is in a range of 40 to 92% of a maximum elongation value. More preferred, the elongation value is in the range of 45 to 85%, and most preferred in the range of 50 to 80% of the maximum elongation value.

In a yet further preferred case, the wire is annealed at a temperature which is $\geq 10$ °C higher than a temperature at which the maximum elongation value is achieved by annealing. More preferably, the temperature is $\geq 50$ °C above the temperature of the maximum elongation and most preferred, the temperature is $\geq 80$ °C above the temperature of the maximum elongation. Often, the temperature is $\leq 150$ °C above the temperature of the maximum elongation. Hence, the wire may be annealed at a temperature which is 10 to 150 °C or 50 to 150 °C or 80 to 150 °C above the temperature of the maximum elongation.

The maximum elongation value is defined as follows: In the general case of a copper based bonding wire, the elongation of the wire can be adjusted by a final annealing step. "Final" in this respect means that no production steps with major impact on the wire's morphology are established thereafter. When choosing the annealing parameters, usually a set of parameters is chosen. In a simple case of annealing the wire, a constant temperature is adjusted in an oven of a given length, wherein the wire is passing through the oven at a constant speed. This exposes every point of the wire to the temperature for a given time, this temperature and this annealing time being the two relevant parameters of the annealing procedure. In other cases, a specific temperature profile of the oven might be used, hence adding further parameters to the system.

In any case, one of the parameters can be chosen as a variable. Then the received elongation value of the wire dependent on this variable results in a graph which generally has a local maximum. This is defined as the maximum elongation value of the wire in the sense of the invention. In case the variable is the annealing temperature, such graph is usually referred to as the "annealing curve".

In prior art, it has been usual to anneal any wire to such maximum elongation value with respect to the variable parameter, as the presence of a local maximum provides for a particularly stable manufacturing condition.

With respect to the present invention, it surprisingly turned out that annealing to a different value below the maximum elongation value can result in beneficial wire properties as the wire morphology can be influenced in a positive way. If the annealing temperature is chosen as the variable parameter, and setting the annealing time as a constant value, it is particularly beneficial if the annealing temperature is chosen at a value which is higher than the annealing temperature of the maximum elongation. In particular, this manufacturing principle can be used to adjust the average grain size of the wire, e.g. towards larger grain sizes. By this adjustment, other properties like e.g. wire softness, wedge-bonding behavior etc. can be influenced in a positive manner.

In order to provide for a good throughput and effective annealing, the core is heated to a minimum annealing temperature of $\geq 650$ °C through its entire cross section during the annealing step (c). Even more preferred, this temperature is $\geq 680$ °C. The core is heated to an annealing temperature of $\leq 1000$ °C through its entire cross section during the annealing step (c). Hence, the core is heated to a temperature in the range of 650 - 1000 °C or 680 - 1000 °C through its entire cross section during the annealing step (c).

In a particularly preferred embodiment, the annealing is performed by strand annealing, allowing for a fast production of the wire with high reproducibility. Strand annealing means that the annealing is done dynamically while the wire is moved through an annealing oven and spooled onto a reel after having left the oven.

In a preferred embodiment the wire is provided in a packed form and the process further comprises the step of (d) transporting and packaging the wire after step (c), wherein the wire is bent with a radius of curvature Rc, wherein Rc is equal to $0.25 \cdot (1/E - 1) \cdot Dr$ or, simplified, $0.25 \cdot Dr/E$, wherein Dr is defined as the diameter of the wire measured in the direction of the radius of curvature, wherein E is a relative elongation of an outer filament of the wire due to the bending; and wherein E is $\leq 0.006$. In a more preferred embodiment, E is $\leq 0.005$ or $\leq 0.004$ and most preferred E is $\leq 0.003$. Usually, E is $\geq 0.0002$. Such procedure ensures that the optimized microstructure of the wire and hence its mechanical properties are not degraded by influences of the final transport, spooling and packaging process. By these measures, it is avoided that the wire experiences an unfavorable mechanical stress after adjusting its microstructure by annealing step (c). In particular, strong bending or other strong deformation of the wire after annealing would have negative effects on the size and distribution of its crystals. This includes effects in which just outer portions of the wire are affected, while the mechanical properties of the wire in its entirety might still be within the ranges according to the invention.

A filament of the wire is defined as a theoretical filament of infinitely small diameter which extends parallel to and in constant distance from a geometrical center line of the wire. Hence an outer filament in the above sense is a filament which extends along the surface of the wire core in a position with maximum radius of curvature.

The limitation of the wire bending is in particular directed to a packing form where the wire is provided on a reel. Depending on the wire diameter, a minimum diameter of the packaging reel needs to be provided according to the parameters given above. Furthermore, it should be taken care that such minimum bending radius is not exceeded when handling the wire. Such handling comprises the procedure of manufacturing the wire as well as the feeding and transporting the wire in a bonding tool.

In a further preferred embodiment, the wire made by the process of the invention has been spooled directly onto a packaging reel after annealing step (c). This means that the wire is not spooled onto an intermediate reel before being spooled onto the final packaging reel. It has turned out that any procedure of spooling the wire has influence on its microstructure and mechanical properties, as any of such procedure puts the wire under mechanical stress. This is true to some extent even if intermediate reels with large diameters are used.

As the diameter of the packaging spool defines a minimum radius of curvature of the wire in the above explained sense, the invention is also related to providing the wire as manufactured according to the invention and packaged on a spool, wherein the packaging spool meets the above given parameters for a radius of curvature.

For wires with a circular cross section made by the process of the invention, unusual properties of the microstructure have been observed. It is likely that these structures are correlated to the good bonding properties. Therefore, for a preferred wire a ratio of an average grain size of a second region (R2) of the wire and an average grain size of a first region (R1) of the wire is 0.05 to 0.8, preferably 0.05 to 0.7 and more preferred 0.1 to 0.6. The first region (R1) of the wire is defined by all points which have a distance of $\leq 10$ % of a smallest diameter of the wire from a geometrical center line of the wire, and wherein the second region (R2) of the wire is defined by all points which have a distance of $\leq 10$ % of a smallest diameter of the wire from the surface of the core. A smallest diameter of the wire is defined as the shortest possible diameter which crosses the wire perpendicular and through its geometrical center line.

Measurement of the average grain size has been performed with Electron Backscattering Diffractometry (EBSD). Pieces of the wire were embedded in a resin and a longitudinal section through the wire in the direction of its center line was grinded. The sectional area of the wire was polished and further prepared by ion-milling. Several measurements on the microtexture of the wire were made. By these measurements, size and distribution of the crystal grains of the wire have been determined.

It has surprisingly turned out that the average size of the crystal grains is significantly smaller in a border region near the surface of the wire than it is in a central region near the center line of the wire. The average grain size seems to decrease rapidly in the radially outwards direction, starting from the center of the wire. Previously known distributions of grain sizes show either a homogenous distribution or an increase of the average grain size with increasing distance from the wire center.

In a possible further development of the process, a step of (e) coating of the copper core with a material of a coating layer, either before or after the step (b) of drawing the precursor, is provided. Examples of coating methods are electroplating, physical vapor deposition and chemical vapor deposition. In such further development of the invention, a coating layer is superimposed over the surface of the core. It is understood that such coating layer is a possible, but not necessary feature of a wire made by the process of the invention. In order to minimize the influence of the material of such coating layer on the bonding process, a thickness of the coating layer is $\leq 0.5$ $\mu$m, and more preferred $\leq 0.2$ $\mu$m. Usually, the thickness of the coating layer is $\geq 20$ nm.

In case of the provision of a coating layer, the layer comprises one of the group of a noble metal, Ti, Ni or Cr as a main component. Particularly preferred examples of noble metals for coating purposes are Pd, Au, Pt and Ag.

The term "superimposed" in the sense of this invention is used to describe the relative position of a first item, e.g. a copper core, with respect to a second item, e.g. a coating layer. Possibly, further items, such as an intermediate layer, might be arranged between the first and the second item. Preferably, the second item is at least partially superimposed over the first item, e.g. for at least 30 %, 50 %, 70 % or 90 % with respect to the total surface of the first item. Most preferably, the second item is completely superimposed over the first item. The term "intermediate layer" in the context of this invention is a region of the wire between the copper core and the coating layer. In this region, material as in the core as well as material as in the coating layer is present in combination.

In a possible embodiment of the invention, the coating layer is provided as an intermediate layer, wherein at least one outer layer is superimposed over the intermediate layer. In such case, the outer layer preferably comprises at least one noble metal as a main component. Such noble metal can particularly be Au or Pd. In a most preferred combination, the intermediate layer comprises Pd and the outer layer comprises Au as a main component, respectively.

In the case of an outer layer being provided, the intermediate layer has a preferred thickness in the range of 5 nm to 100 nm.

In one preferred embodiment, the wire has a circular cross sectional shape, wherein a ratio between a shortest path and a longest path through the cross sectional area is between 0.8 and 1.0. Such wire is referred to as a wire with circular cross section.

In another preferred embodiment, the wire is shaped like a ribbon, wherein a ratio between a shortest path and a longest path through the cross sectional area is between 0.02 and 0.5.

According to the demands, the process of the invention can further comprise a step of (f) rolling the wire to the shape of a ribbon prior to step (c). This ensures that a shaping of a circular wire into a ribbon does not influence the microstructure of the final wire.

DESCRIPTION OF THE FIGURES

The subject matter of the invention is exemplified in the figures. The figures, however, are not intended to limit the scope of the invention or the claims in any way.

In Fig. 1, a wire 1 is depicted.

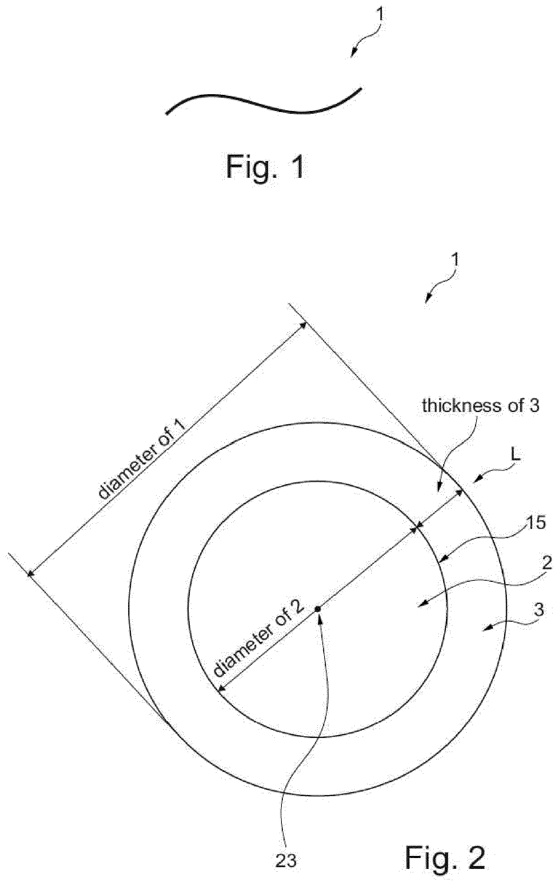

Fig. 2 shows a cross sectional view of wire 1. In the cross sectional view, a copper core 2 is in the middle of the cross sectional view. The copper core 2 is encompassed by a coating layer 3. On the limit of copper wire 2, a surface 15 of the copper core is located. On a line L through the center 23 of wire 1 the diameter of copper core 2 is shown as the end to end distance between the intersections of line L with the surface 15. The diameter of wire 1 is the end-to-end distance between the intersections of line L through the center 23 and the outer limit of wire 1. Besides, the thickness of coating layer 3 is depicted. The thickness of a coating layer 3 is exaggerated in fig. 2. If a coating layer 3 is provided, its typical thickness is very small compared to the core diameter, e.g. $\leq 1\%$ of the core diameter.
It is understood that the coating layer 3 of the wire 1 is optional. For a most preferred embodiment, no coating layer is provided on the wire core.

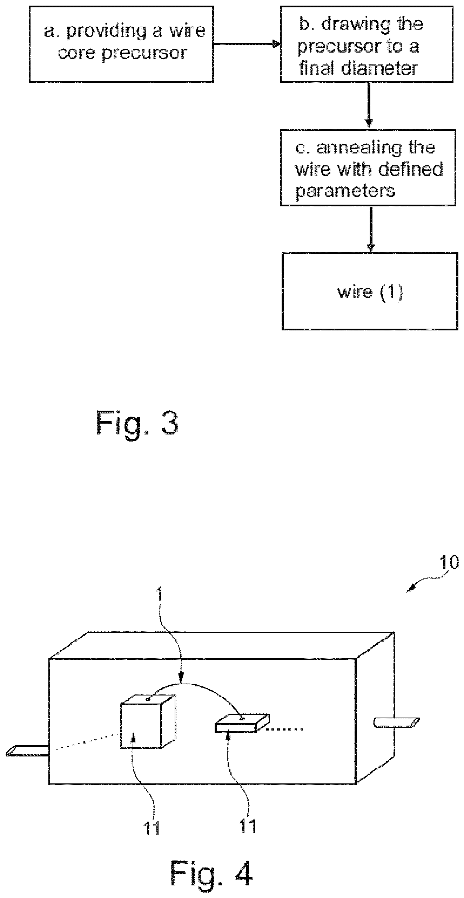

Fig. 3 shows a process for manufacturing a wire according to the invention.

Fig. 4 depicts a module in the form of an electric device 10, comprising two elements 11 and a wire 1. The wire 1 electrically connects the two elements 11. The dashed lines mean further connections or circuitry, which connect the elements 11 with external wiring of a packaging device surrounding the elements 11. The elements 11 can comprise bond pads, lead fingers, integrated circuits, LEDs or the like.

Fig. 5 shows an annealing curve for a thick wire consisting of a 4N-copper core without a coating. One annealing window according to prior art and one annealing window according to an example of the invention are marked.

Fig. 6 shows an EBSD measurement on a longitudinal section through a wire made according to the invention. The wire has a circular cross section with 300 $\mu$m diameter.

TEST METHODS

All tests and measurements were conducted at T = 20 °C and a relative humidity of 50 %.
When measuring the average grain size of the crystal grains, Electron Backscattering Diffractometry (EBSD) is used herein. Although EBSD is a method which can determine the orientations of different crystal grains, for the present purpose the method is used for a mere measurement of the grain diameters.
Measurement of wedge-bonding processes has been done by standard procedure. The definition of a process parameter window for bonding wires is known in the art and is widely used to compare different wires. All embodiments of wires made by the process of the invention described hereafter have shown excellent bonding properties.

EXAMPLES

The invention is further exemplified by examples. These examples serve for exemplary elucidation of the invention and are not intended to limit the scope of the invention or the claims in any way.

Example 1

A quantity of copper material of ≥ 99.99 % purity ("4N-copper") was molten in a crucible. No further substances were added to the melt. Then a wire core precursor was cast from the melt.
The chemical composition of the Cu wire was controlled using an Inductively Coupled Plasma (ICP) instrument (Perkin Elmer ICP-OES 7100DV). The Cu wires were dissolved in concentrated nitric acid and the solution was used for ICP analysis. The methodology to test highly pure Cu wire was established with the equipment manufacturer as per the well-known technique adopted for bulk Cu.
The wire core precursor was then drawn in several drawing steps to form the wire core 2 with a specified diameter. This wire had a mostly circular cross section, wherein a ration of a longest and a shortest diameter was between 0.8 and 1.0.
In order to confirm the beneficial effects of the invention for different diameters, a selection of wires with different diameters was manufactured. Table 1 below shows a list of measured data for different wire diameters at different steps of the manufacturing process:

(Table 1: Data for different wires made by the process of the invention)

| No | Diameter [$\mu$m] | TS1 [N/mm$^2$] | EL1 [%] | YS1 [N/mm$^2$] | TS2 [N/mm$^2$] | EL2 [%] | YS2 [N/mm$^2$] |
|----|------|-------|-------|------|-------|-------|------|
| 1 | 500 | 215.6 | 29.06 | 70.8 | 218.8 | 33.88 | 91.2 |
| 2 | 400 | 224.2 | 26.41 | 75.0 | 226.6 | 28.9 | 90.7 |
| 3 | 300 | 225.3 | 21.2 | 65.2 | 225.5 | 23.05 | 85.6 |

(continued)

| No | Diameter [$\mu$m] | TS1 [N/mm$^2$] | EL1 [%] | YS1 [N/mm$^2$] | TS2 [N/mm$^2$] | EL2 [%] | YS2 [N/mm$^2$] |
|---|---|---|---|---|---|---|---|
| 4 | 125 | 207.5 | 20.58 | 68.0 | 205.8 | 19.04 | 90.2 |

Explanation on the data:

TS1: Tensile strength of the wire directly after annealing oven;

EL1: Elongation of the wire directly after annealing oven;

YS1: Yield strength of the wire directly after annealing oven;

TS2: Tensile strength of the wire after spooling onto packaging reel;

EL2: Elongation of the wire after spooling onto packaging reel;

YS2: Yield strength of the wire after spooling onto packaging reel.

It is noted that the yield strength of the wire in the sense of the invention is "YS2" of the above data, as this refers to the finished product. The significant differences between the result of YS1 and YS2 are explained with the additional mechanical impact on the wire during transport and spooling. Optimization of this wire handling after the annealing procedure can reduce the increase in yield strength seen here.

In the present procedure of manufacturing the wires, the wires have first been spooled onto an intermediate reel after leaving the annealing oven. Then, the wires have been re-spooled onto a packaging reel. This further adds to a difference between the values YS1 and YS2. In a preferred variant of the manufacturing procedure, the wire was directly spooled onto a packaging reel.

In order to minimize the mechanical stress caused by the spooling, the used reels as well as all guiding rolls had a minimum diameter in order to keep the bending radii occuring to the wire above a minimum value. The preferred minimum bending radii, or radii of curvature, increase with the wire diameter.

This radius of curvature Rc is equal to 0.25 · (1/E -1) · Dr, wherein

- Dr is defined as the diameter of the wire measured in the direction of the radius of curvature;
- E is a relative elongation of an outer filament of the wire due to the bending; and
- E is $\leq$ 0.006.

In the present examples, E was chosen as small as 0.002. This means, for example, that the diameter of the reels for the 300 $\mu$m wire (sample No 1) was chosen as 10 cm (= 5 cm radius of curvature). This relates to a parameter E = 0.0015:

$$5 \text{ cm} = 0.25 * 0.03 \text{ cm} / 0.0015$$

In the manufacturing arrangement, the item (reel, guidance roll etc.) with the smallest bending radius primarily defines the mechanical stress of the wire after annealing. Hence it is preferred to have all reels and rolls with the same radius, and to minimize their number as far as possible.

It is further noted that the tensile strength TS1, TS2 of the wire is largely unaffected by the measures described herein. Neither the special annealing according to the invention nor mechanical stress due to the packaging procedure after annealing changes this wire property in a significant way.

Table 2 below shows more detail on the annealing parameters used for the strand annealing of the wires of table 1:

(Table 2: Annealing parameters for the wires of table 1)

| No | Diameter [$\mu$m] | Oven Temperature [°C] | Speed of the wire [m/min] | Oven length [m] |
|---|---|---|---|---|
| 1 | 500 | 800 | 3 | 0.82 |
| 2 | 400 | 800 | 5 | 0.82 |

(continued)

| No | Diameter [$\mu$m] | Oven Temperature [°C] | Speed of the wire [m/min] | Oven length [m] |
|----|---------|----------|----|------|
| 3 | 300 | 800 | 10 | 0.82 |
| 4 | 125 | 700 | 10 | 0.82 |

It becomes clear from table 2 that the annealing time has been varied by changing the wire transport speed, using strand annealing.

Further to the annealing time, the annealing temperature has been subject to variation.

Table 3 below shows comparison examples which do not refer to the invention. In these examples, the same base material of wires had been annealed with different annealing parameters. In each case, the annealing parameters had been varied until a maximum elongation value EL1max, measured directly after the annealing oven, had been achieved. For these wires, the values TS1 and YS1, measured directly after the annealing oven (see above explanation for table 1), are given.

(Table 3: Comparative examples, wherein annealing aimed at maximum elongation values)

| No | Diameter [$\mu$m] | Oven Temperature [°C] | Speed of the wire [m/min] | Oven length [m] | TS1 [N/mm$^2$] | EL1max [%] | YS1 [N/mm$^2$] | YS2 [N/mm$^2$] |
|----|---------|----------|----|------|------|-------|------|-------|
| 1 | 500 | 800 | 5 | 0.82 | 219.7 | 37.61 | 81.0 | 101.5 |
| 2 | 400 | 800 | 10 | 0.82 | 228.6 | 36.11 | 90.9 | 110.5 |
| 3 | 300 | 600 | 10 | 0.82 | 226.6 | 32.93 | 95.1 | 112.3 |
| 4 | 125 | 600 | 10 | 0.82 | 207.9 | 28.6 | 93.7 | 108.2 |

Yield strength values YS2 for finished products are significantly higher than for the wires made by the process of the invention. For none of the comparative wires, the yield strength value was below 100 N/mm$^2$ for the finished product.

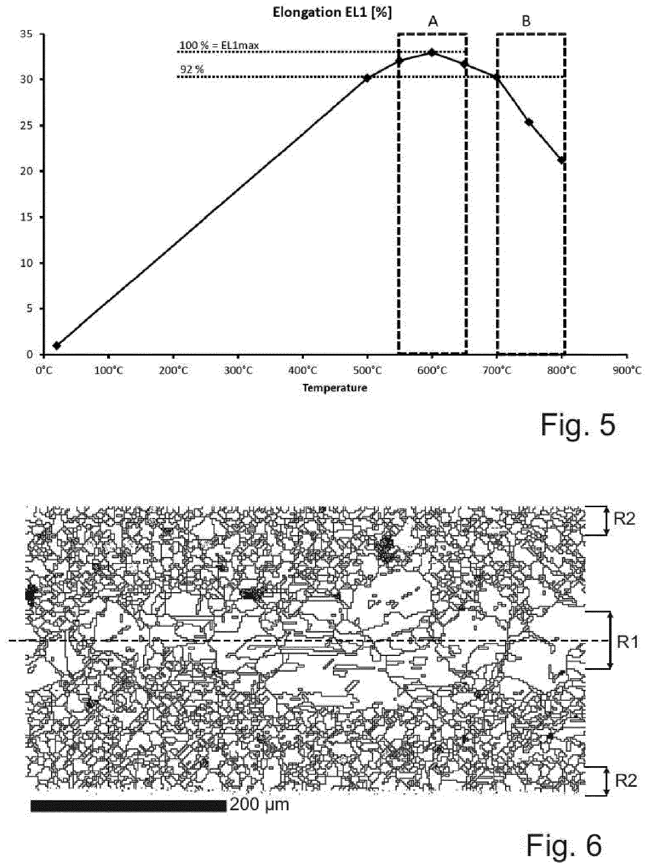

Concerning the annealing procedure of a wire made by the process of the invention, reference is made to fig. 5. This figure shows an annealing curve for the 300 $\mu$m wire. In this curve, the annealing has been performed at different temperatures, while annealing time is kept constant. The elongation value EL1 directly after the annealing oven is measured and displayed versus the annealing temperature.

In the present method of strand annealing, the annealing time is calculated from the values of wire speed and oven length. It is understood that the wires made by the process of the invention are not limited to strand annealing.

As it is usually the case, the annealing curve exhibits a local maximum, which here is located at about 600 °C. It is understood that the annealing temperature of the maximum elongation value also depends on the annealing time.

Two annealing windows A and B are displayed in fig. 5. The first window A is arranged symmetrically around the local maximum and refers to annealing of bonding wires according to the prior art. This type of annealing at or close to the local maximum is traditionally used because it gives a good process stability and reproducibility.

The wires made by the process of the invention have been annealed with parameters from the second annealing window B. This window is arranged about the high end tail of the annealing curve. A lower temperature border of window B is defined when the elongation has dropped to $\leq$ 92% of the maximum elongation value EL1max. The upper temperature border of window B is only defined by a lower limit of the yield strength which is to be obtained. It is pointed out that such upper temperature border can be different depending on the mechanical stress the wire experiences after the annealing procedure, contributing to an increase of the yield strength.

In further experiments, the crystal microstructure of the wire made by the process of the invention was measured and evaluated. Fig. 6 shows a grain structure of the above described sample No 3 wire (300 $\mu$m diameter). The wire sample has been sectioned along its center line. Two different regions R1 and R2 are displayed, wherein the first region R1 is arranged about the center line.

The second region R2 is arranged below the surface of the wire. The radial width of each of the regions is 10% of the wire diameter.

It is obvious from the displayed grain structure that the average grain in the center region R1 is significantly bigger than the average grain in the near-surface region R2. Evaluation of the measurement gives an average grain size of 25 $\mu$m in the center region R1. The average grain size in the surface region R2 is 11 $\mu$m. The ratio of these average grain sizes in the different regions is 11 $\mu$m / 25 $\mu$m = 0.44.

Bonding tests have shown that the wires made by the process of the invention show excellent bonding properties.

Furthermore, the handling of the wires in the bonding tools and the bonding process stability is increased due to the high softness of the wires.

Example 2

As a second example of the invention, a bonding wire in the form of a ribbon is manufactured. All manufacturing steps are performed according to the first example described above, apart from an additional step of flattening the wire core prior to the annealing step. The flattening of the wire is achieved by rolling the wire. The resulting ribbon has a ratio of its shortest diameter by its longest diameter of 0.1. Its shortest diameter is 100 $\mu$m and its longest diameter is 1000 $\mu$m, the cross sectional area being roughly 100,000 $\mu$m$^2$.

It is noted that the annealing procedure and the adjusted values for YS2 for the packaged product are the same for the ribbon as for the above described circular wires. Concerning the minimum radii of curvature to be obeyed, the ribbon is regularly spooled about its shorter diameter and hence this diameter is the relevant parameter for choosing the diameters of the reels and guidance rolls.

**Claims**

1.  A process for the manufacture of a bonding wire comprising a core with a surface, wherein the core comprises $\geq$ 98.0% copper and has a cross sectional area in the range of 7500 to 600000 $\mu$m$^2$ and an elastic limit RP0.2 (yield strength) in the range of 40 to 95 N/mm$^2$, the process comprising the steps of

    (a) providing a copper core precursor;
    (b) drawing the precursor until a final diameter of the wire core is reached;
    (c) annealing the drawn wire at a minimum annealing temperature in the range of 650 to 1000 °C through its entire cross section for a minimum annealing time in the range of 4 seconds to 2 hours.

2.  The process of claim 1,
    wherein the annealing is strand annealing.

3.  The process of claim 1 or 2,
    wherein the wire is annealed at a temperature which is 10 to 150 °C above the temperature of the maximum elongation.

4.  The process of claim 1, 2 or 3 further comprising the step of (d) transporting and packaging the wire after step (c), wherein the wire is bent with a radius of curvature Rc, wherein Rc is equal to 0.25 · Dr/E, wherein Dr is defined as the diameter of the wire measured in the direction of the radius of curvature;
    wherein E is a relative elongation of an outer filament of the wire due to the bending; and wherein E is in the range of 0.0002 to 0.006.

5.  The process of any one of the preceding claims,
    wherein the process further comprises the step of
    (e) coating the copper core with a material of a coating layer, either before or after step (b), so as to superimpose a coating layer over the surface of the core.

6.  The process of claim 5,
    wherein the coating layer has a thickness of 20 nm to 0.5 $\mu$m.

7.  The process of claim 5 or 6,
    wherein the coating layer comprises one of the group of a noble metal, Ti, Ni or Cr as a main component.

8.  The process of any one of claims 5 to 7,
    wherein the coating layer is provided as an intermediate layer, wherein at least one outer layer is superimposed over the intermediate layer.

9.  The process of claim 8,
    wherein the outer layer comprises a noble metal as a main component.

10. The process of claim 8 or 9,

wherein the intermediate layer has a thickness in the range of 5 nm to 100 nm.

**11.** The process of any one of the preceding claims,
further comprising the step of
(f) rolling the wire to the shape of a ribbon prior to step (c).

**12.** The process of any one of claims 1 to 10,
wherein the wire has a circular cross sectional shape, wherein a ratio between a shortest path and a longest path through the cross sectional area is between 0.8 and 1.0.

**13.** The process of claim 11,
wherein a ratio between a shortest path and a longest path through the cross sectional area is between 0.02 and 0.5.

**14.** The process of any one of the preceding claims,
wherein the wire exhibits a ratio of an average grain size of a second region (R2) of the wire and an average grain size of a first region (R1) of the wire of 0.05 to 0.8,
wherein the first region (R1) of the wire is defined by all points which have a distance of $\leq$ 10% of a smallest diameter of the wire from a geometrical center line of the wire, and
wherein the second region (R2) of the wire is defined by all points which have a distance of $\leq$ 10% of a smallest diameter of the wire from the surface of the core.

**15.** The process of any one of the preceding claims,
wherein the wire has an elongation value after annealing of 40 to 92% of a maximum elongation value.

**Patentansprüche**

**1.** Verfahren zur Herstellung eines Bonddrahts, der einen Kern mit einer Oberfläche umfasst, wobei der Kern $\geq$98,0 % Kupfer umfasst und eine Querschnittsfläche in dem Bereich von 7500 bis 600000 $\mu m^2$ und eine Elastizitätsgrenze RP0,2 (Fließgrenze) in dem Bereich von 40 bis 95 N/mm$^2$ aufweist, wobei das Verfahren die folgenden Schritte umfasst:

(a) Bereitstellen eines Kupferkernvorläufers;
(b) Ziehen des Vorläufers, bis ein Enddurchmesser des Drahtkerns erreicht ist;
(c) Ausglühen des gezogenen Drahts bei einer minimalen Ausglühtemperatur in dem Bereich von 650 bis 1000 °C über seinen gesamten Querschnitt während einer minimalen Ausglühzeit in dem Bereich von 4 Sekunden bis 2 Stunden.

**2.** Verfahren nach Anspruch 1,
wobei das Ausglühen ein Strangausglühen ist.

**3.** Verfahren nach Anspruch 1 oder 2,
wobei der Draht bei einer Temperatur ausgeglüht wird, die 10 bis 150 °C über der Temperatur der Höchstdehnung liegt.

**4.** Verfahren nach Anspruch 1, 2 oder 3, das ferner den Schritt (d) des Transportierens und Verpackens des Drahts nach dem Schritt (c) umfasst,
wobei der Draht mit einem Krümmungsradius Rc gebogen wird, wobei Rc gleich 0,25 · Dr/E ist,
wobei Dr als der Durchmesser des Drahts, gemessen in der Richtung des Krümmungsradius, definiert ist;
wobei E eine relative Dehnung eines Außenfilaments des Drahts wegen des Biegens ist; und
wobei E in dem Bereich von 0,0002 bis 0,006 liegt.

**5.** Verfahren nach einem der vorhergehenden Ansprüche,
wobei das Verfahren ferner den folgenden Schritt umfasst:
(e) Beschichten des Kupferdrahts mit einem Material einer Beschichtungsschicht, entweder vor oder nach dem Schritt (b), um über der Oberfläche des Kerns eine Beschichtungsschicht anzuordnen.

**6.** Verfahren nach Anspruch 5,

wobei die Beschichtungsschicht eine Dicke von 20 nm bis 0,5 μm aufweist.

7. Verfahren nach Anspruch 5 oder 6,
wobei die Beschichtungsschicht eine der Gruppe aus einem Edelmetall, Ti, Ni oder Cr als eine Hauptkomponente umfasst.

8. Verfahren nach einem der Ansprüche 5 bis 7,
wobei die Beschichtungsschicht als eine Zwischenschicht vorgesehen ist, wobei über der Zwischenschicht wenigstens eine Außenschicht angeordnet wird.

9. Verfahren nach Anspruch 8,
wobei die Außenschicht ein Edelmetall als eine Hauptkomponente umfasst.

10. Verfahren nach Anspruch 8 oder 9,
wobei die Zwischenschicht eine Dicke in dem Bereich von 5 nm bis 100 nm aufweist.

11. Verfahren nach einem der vorhergehenden Ansprüche,
das ferner den folgenden Schritt umfasst:
(f) Walzen des Drahts zu einer Form eines Bands vor dem Schritt (c).

12. Verfahren nach einem der Ansprüche 1 bis 10,
wobei der Draht einen kreisförmigen Querschnitt aufweist, wobei ein Verhältnis zwischen einem kürzesten Weg und einem längsten Wert über die Querschnittsfläche zwischen 0,8 und 1,0 liegt.

13. Verfahren nach Anspruch 11,
wobei ein Verhältnis zwischen einem kürzesten Weg und einem längsten Weg über die Querschnittsfläche zwischen 0,02 und 0,5 ist.

14. Verfahren nach einem der vorhergehenden Ansprüche,
wobei der Draht ein Verhältnis einer durchschnittlichen Korngröße eines zweiten Gebiets (R2) des Drahts und einer durchschnittlichen Korngröße eines ersten Gebiets (R1) des Drahts von 0,05 bis 0,8 zeigt,
wobei das erste Gebiet (R1) des Drahts durch alle Punkte definiert ist, die eine Entfernung von ≤10 % eines kleinsten Durchmessers des Drahts von einer geometrischen Mittellinie des Drahts aufweisen, und
wobei das zweite Gebiet (R2) des Drahts durch alle Punkte definiert ist, die eine Entfernung von ≤10 % eines kleinsten Durchmessers des Drahts von der Oberfläche des Kerns aufweisen.

15. Verfahren nach einem der vorhergehenden Ansprüche,
wobei der Draht einen Dehnungswert nach dem Ausglühen von 40 bis 92 % eines Höchstdehnungswerts aufweist.

**Revendications**

1. Un procédé pour la fabrication d'un fil de liaison comprenant une âme avec une surface, l'âme renfermant ≥ 98,0% de cuivre et ayant une section transversale de l'ordre de 7500 à 600000 $\mu m^2$ ainsi qu'une limite élastique RP0.2 (limite d'élasticité) de l'ordre de 40 à 95 N/mm$^2$, le procédé comprenant les étapes suivantes :

(a) Fourniture d'un précurseur d'âme en cuivre;
(b) Tréfilage du précurseur jusqu'à ce qu'un diamètre final de l'âme du fil soit atteint;
(c) Recuit du fil tréfilé à une température de recuit minimum dans la plage de 650 à 1000°C à travers toute sa section transversale pendant un temps de recuit minimum de 4 secondes à 2 heures.

2. Le procédé de la revendication 1,
le recuit étant un recuit de brins.

3. Le procédé de la revendication 1 ou 2,
le fil étant recuit à une température qui est 10 à 150°C supérieure à la température de l'allongement maximum.

4. Le procédé de la revendication 1, 2 ou 3, comprenant en outre l'étape (d) Transport et emballage du fil après l'étape (c),

le fil étant courbé avec un rayon de courbure Rc, Rc étant égal à 0,25 . Dr/E, Dr étant défini comme le diamètre du fil mesuré dans la direction du rayon de courbure;

E étant un allongement relatif d'un filament extérieur du fil en raison de la courbure et E étant situé dans la plage de 0,0002 à 0,006.

5. Le procédé de l'une des revendications précédentes,
le procédé comprenant en outre l'étape
(e) Revêtement de l'âme en cuivre avec un matériau d'une couche d'enrobage, avant ou après l'étape (b), de façon à superposer une couche d'enrobage au-dessus de la surface de l'âme.

6. Le procédé de la revendication 5,
la couche d'enrobage ayant une épaisseur de 20 nm à 0,5 $\mu$m.

7. Le procédé de la revendication 5 ou 6,
la couche d'enrobage comprenant l'un des éléments du groupe composé du métal noble, Ti, Ni ou Cr, comme composant principal.

8. Le procédé de l'une des revendications 5 à 7,
la couche d'enrobage étant fournie comme couche intermédiaire, au moins une couche extérieure étant superposée au-dessus de la couche intermédiaire.

9. Le procédé de la revendication 8,
la couche extérieure comprenant un métal noble comme composant principal.

10. Le procédé de la revendication 8 ou 9,
la couche intermédiaire ayant une épaisseur dans la plage de 5 nm à 100 nm.

11. Le procédé de l'une des revendications précédentes,
comprenant en outre l'étape
(f) Enroulement du fil dans la forme d'un ruban avant l'étape (c).

12. Le procédé de l'une des revendications 1 à 10,
le fil ayant une section transversale de forme circulaire, un rapport entre le chemin le plus court et le chemin le plus long à travers la section transversale étant compris entre 0,8 et 1,0.

13. Le procédé de la revendication 11,
un rapport entre le chemin le plus court et le chemin le plus long à travers la section transversale étant compris entre 0,02 et 0,5.

14. Le procédé de l'une des revendications précédentes,
le fil montrant un rapport entre une grosseur de grain moyenne d'une deuxième région (R2) du fil et une grosseur de grain moyenne d'une première région (R1) du fil de 0,05 à 0,8,
la première région (R1) du fil étant définie par tous les points qui ont une distance ≤ 10% d'un plus petit diamètre du fil depuis une ligne centrale géométrique du fil, et
la deuxième région (R2) du fil étant définie par tous les points qui ont une distance ≤ 10% d'un plus petit diamètre du fil depuis la surface de l'âme.

15. Le procédé de l'une des revendications précédentes,
le fil ayant une valeur d'allongement après recuit de 40 à 92% d'une valeur d'allongement maximum.

1

## Fig. 1

1

diameter of 1

thickness of 3

L

15

2

3

diameter of 2

23

## Fig. 2

| a. providing a wire core precursor | → | b. drawing the precursor to a final diameter |
|---|---|---|

↓

c. annealing the wire with defined parameters

↓

wire (1)

# Fig. 3

# Fig. 4

Fig. 5

Fig. 6

**EP 3 167 482 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7952028 B2